# FASCICULE DE BREVET EUROPEEN

(11) **EP 3 550 158 B1**
(45) Date de publication et mention de la délivrance du brevet: **16.12.2020**
(21) Numéro de dépôt: 19164930.0
(22) Date de dépôt: 25.03.2019
(51) Int. Cl.: F16B 2/24, F24S 25/634, F16B 1/00

(54) **AGRAFE DE FIXATION POUR CHÂSSIS PHOTOVOLTAÏQUE À MONTAGE PAR INSERTION PUIS COULISSEMENT DANS UNE FENTE D'UNE PAROI DE SUPPORT**
BEFESTIGUNGSKLAMMER FÜR FOTOVOLTAIK-RAHMEN ZUM MONTIEREN DURCH EINSETZEN UND ANSCHLIESSENDES EINSCHIEBEN IN EINEN SCHLITZ EINER STÜTZWAND
CLIP FOR ATTACHING PHOTOVOLTAIC FRAME FOR MOUNTING BY INSERTION AND THEN SLIDING IN A SLOT OF A SUPPORTING WALL

(30) Priorité: 04.04.2018 FR 1852910
(43) Date de publication de la demande: 09.10.2019
(73) Titulaire: A. Raymond et Cie, 38000 Grenoble (FR)
(72) Inventeur: Legall, Antoine, 38600 Fontaine (FR); Turlot, Emmanuel, 38000 Grenoble (FR); Chevrier, Jean-Baptiste, 38660 Saint Vincent de Mercuze (FR)
(74) Mandataire: Verriest, Philippe

(56) Documents cités:
- WO-A1-2012/167895
- WO-A2-2014/008087
- DE-A1-102010 029 820
- US-A- 3 298 646
- US-A1- 2006 102 820

## Description

### DOMAINE TECHNIQUE

La présente invention concerne une agrafe de fixation adaptée à la fixation d'un châssis photovoltaïque contre une face avant d'une paroi de support.

Une application possible visée concerne celle où la paroi de support est constituée par l'une des ailes d'une poutre porteuse elle-même destinée à être maintenue à distance du sol au moyen de tout piétement adapté à la poutre porteuse et au terrain.

### ETAT DE LA TECHNIQUE ANTERIEURE

Il s'agit d'un problème connu que de devoir fixer chacun des châssis photovoltaïques d'une installation photovoltaïque sur une ou plusieurs poutre(s) porteuse(s). Une technique connue consiste à utiliser une pluralité d'agrafes de fixation pour maintenir chaque châssis photovoltaïque, où chaque agrafe de fixation permet de maintenir le châssis photovoltaïque avec lequel elle coopère contre une face avant d'une paroi de support délimitée par l'une des poutres porteuses.

Il est également connu que, pour répondre à certaines exigences réglementaires, une agrafe de fixation doit avoir la capacité de mettre au même potentiel électrique le châssis photovoltaïque et la paroi de support.

A titre d'exemple, le document EP-A1-2867541 au nom de la demanderesse décrit un appareil de fixation de châssis photovoltaïque comprenant un élément de fixation en une seule pièce pour relier le châssis photovoltaïque à un support allongé. L'élément de fixation comprend un corps incluant une paire de fentes permettant la réception d'un segment de châssis photovoltaïque, une paire d'ailes flexibles à encliqueter dans le support allongé qui présente une section creuse en forme de U à l'intérieur de laquelle le corps vient se loger au moment de l'encliquetage des ailes flexibles, et une languette flexible agencée dans la partie haute du corps pour venir entailler le châssis photovoltaïque afin de l'immobiliser à l'intérieur des fentes.

Même si cette solution est efficace au sujet de la robustesse de la fixation obtenue, un inconvénient réside dans le fait que la seule possibilité de réglage au moment du montage repose sur la capacité d'ajustement de la position occupée par chaque élément de fixation le long de chacun des supports allongés. Il en résulte des difficultés de montage et l'installation photovoltaïque peut en outre n'être implantée que sur des terrains sensiblement plats, ce qui est un aspect limitant pour son développement.

Outre répondre au problème ci-dessus, des difficultés supplémentaires sont de parvenir à ce que les agrafes de fixation soient faciles à mettre en œuvre pour le poseur, soient peu onéreuses pour des raisons évidentes de coût, et confèrent une très grande résistance de la fixation qu'elle assure que ce soit vis-à-vis des efforts d'arrachement qui peuvent avoisiner 120kg par agrafe de fixation ou vis-à-vis des efforts de cisaillement qui peuvent être élevés également.

Ces problématiques de résistance face aux efforts d'arrachement et de cisaillement deviennent de plus en plus complexes à gérer en raison de la tendance actuelle qui consiste à développer des châssis photovoltaïques de plus en plus grands afin de diminuer les coûts de montage des installations photovoltaïques.

Il existe, à l'image de celles décrites dans les documents US2006/102820A1 et US3298646A, des solutions mettant en œuvre une agrafe de fixation contenant une tête d'appui et un pied de contre-appui reliés entre eux par un corps pour définir une mâchoire. Mais ces solutions ne concernent pas le domaine de la fixation de panneaux photovoltaïques et ne présentent pas une robustesse suffisante pour répondre aux besoins en terme de résistance à l'arrachement et au cisaillement.

### EXPOSE DE L'INVENTION

La présente invention a pour but de proposer une agrafe de fixation adaptée à la fixation d'un châssis photovoltaïque contre une face avant d'une paroi de support qui réponde aux problématiques énoncées ci-avant en lien avec l'art antérieur.

Notamment, le but de l'invention est de proposer une agrafe de fixation qui réponde à au moins l'un des objectifs suivants :
- être économique,
- favoriser un montage aisé,
- rendre possible des installations sur des terrains non plats,
- être très robuste à l'arrachement et au cisaillement.

Ce but peut être atteint grâce à une agrafe de fixation adaptée à la fixation d'un châssis photovoltaïque contre une face avant d'une paroi de support, l'agrafe de fixation étant une pièce métallique électriquement conductrice d'un seul tenant conformée pour délimiter :
- une tête d'appui ;
- un pied de contre-appui ;
- un corps de liaison reliant le pied de contre-appui à la tête d'appui de sorte que la tête d'appui et le pied de contre-appui sont décalés l'un par rapport à l'autre suivant une direction longitudinale de l'agrafe de fixation par un intervalle déterminé, le corps de liaison étant adapté à traverser l'épaisseur de la paroi de support à travers une fente ménagée dans la paroi de support, par insertion longitudinale de la tête d'appui à travers la fente pour positionner la tête d'appui et le pied de contre-appui respectivement de part et d'autre de la paroi de support, et à coulisser le long de la fente par un mouvement de coulissement d'ensemble de l'agrafe de fixation suivant une direction transversale de l'agrafe de fixation ;
agrafe de fixation dans laquelle l'intervalle déterminé entre la tête d'appui et le pied de contre-appui est adapté pour que la tête d'appui et le pied de contre-appui constituent une mâchoire susceptible de conjointement recevoir transversalement un segment de la paroi de support et un segment de châssis photovoltaïque dans une configuration où le châssis photovoltaïque est en appui contre la face avant de la paroi de support,
dans laquelle le pied de contre-appui comprend au moins une aile latérale d'appui positionnée longitudinalement pour venir en appui longitudinal contre une face arrière de la paroi de support lorsque le châssis photovoltaïque et la paroi de support sont transversalement engagés dans la mâchoire,
dans laquelle la tête d'appui comprend au moins un élément d'accrochage adapté pour accrocher le châssis photovoltaïque afin d'immobiliser transversalement le châssis photovoltaïque dans la mâchoire,
dans laquelle la tête d'appui et/ou le pied de contre-appui comprend au moins une aile de mise en tension mécanique dont une déformation élastique et/ou un déplacement, résultant de l'action d'engagement transversal du segment de châssis photovoltaïque et du segment de paroi de support dans l'intervalle déterminé entre la tête d'appui et le pied de contre-appui, permet à la tête d'appui et au pied de contre-appui d'exercer un serrage longitudinal du châssis photovoltaïque et de la paroi de support dans la mâchoire,
dans laquelle le corps de liaison est constitué par deux parois latérales délimitées par l'agrafe de fixation, décalées entre elles suivant une direction latérale de l'agrafe de fixation et connectées entre elles à l'une de leurs extrémités longitudinales au niveau de la tête d'appui par une zone de pliage, leurs extrémités longitudinales opposées étant indépendantes l'une de l'autre au niveau du pied de contre-appui, ladite au moins une aile latérale d'appui étant solidaire de l'une des parois latérales de sorte à s'étendre latéralement en saillie par rapport à la paroi latérale dont elle est solidaire.

Certains aspects préférés mais non limitatifs de cette agrafe de fixation sont les suivants.

La tête d'appui peut comprendre un bras supérieur s'étendant transversalement en porte-à-faux depuis la zone de pliage et à l'aplomb du pied de contre-appui suivant la direction longitudinale.

Ladite au moins une aile de mise en tension mécanique peut être constituée par ladite au moins une aile latérale d'appui et ladite au moins une aile latérale d'appui est alors inclinée de sorte à former un angle par rapport à la direction latérale et est raccordée à la paroi latérale dont elle est solidaire par une zone recourbée élastiquement déformable telle que l'aile latérale d'appui est susceptible de s'abaisser longitudinalement, au moins par déformation élastique de ladite zone recourbée élastiquement déformable, sous l'action de l'engagement transversal du segment de châssis photovoltaïque et du segment de paroi de support dans l'intervalle déterminé entre la tête d'appui et le pied de contre-appui.

Chacune des ailes latérales d'appui peut être subdivisée suivant la direction transversale en au moins une aile latérale d'appui supérieure et en au moins une aile latérale d'appui inférieure, ladite au moins une aile latérale d'appui supérieure étant en saillie du côté de la tête d'appui, suivant la direction longitudinale, par rapport à ladite au moins une aile latérale d'appui inférieure.

L'élément d'accrochage peut comprendre un ergot de retenue et un épaulement solidaires du bras supérieur en étant décalés l'un par rapport à l'autre suivant la direction transversale le long du bras supérieur, et délimitant entre eux une encoche qui débouche du côté de l'intérieur de la mâchoire et adaptée pour recevoir une nervure du châssis photovoltaïque.

Les parois latérales peuvent être inclinées de sorte à former un angle avec la direction longitudinale pour s'approcher l'une de l'autre en s'approchant de la zone de pliage, les parois latérales étant susceptibles de se rapprocher latéralement l'une de l'autre par déformation élastique de la zone de pliage, le rappel élastique de la matière de la zone de pliage assurant un rappel latéral des parois latérales vers l'extérieur suivant la direction latérale.

Chaque paroi latérale peut comprendre une saillie latérale de maintien susceptible de venir buter contre la face avant de la paroi de support, au niveau des bords de la fente, après l'insertion longitudinale la tête d'appui à travers la fente.

La tête d'appui peut comprendre deux ailes flexibles indépendantes l'une de l'autre où chaque aile flexible est raccordée au bras supérieur par une zone pliée de sorte à s'étendre chacune en direction du pied de contre-appui de manière inclinée en formant un angle avec la direction longitudinale, les deux ailes flexibles convergeant l'une vers l'autre en s'approchant du bras supérieur, chaque aile flexible étant susceptible de s'écarter latéralement, par déformation élastique de ladite zone pliée et/ou par déformation élastique intrinsèque de l'aile flexible, sous l'action de l'engagement transversal du segment de châssis photovoltaïque et du segment de paroi de support dans l'intervalle déterminé entre la tête d'appui et le pied de contre-appui et ladite au moins une aile de mise en tension mécanique est constituée par les deux ailes flexibles.

L'élément d'accrochage peut comprendre une série de dents d'accrochage échelonnées transversalement le long d'un bord distal de l'aile flexible opposé à son bord proximal lié à la zone pliée, les dents d'accrochage étant adaptées pour entailler le segment de châssis photovoltaïque sous l'action de l'engagement transversal du segment de châssis photovoltaïque dans l'intervalle déterminé entre la tête d'appui et le pied de contre-appui.

Il est également proposé une installation photovoltaïque comprenant au moins un châssis photovoltaïque, au moins une paroi de support délimitant une face avant contre laquelle le châssis photovoltaïque est en appui et dans laquelle est ménagée au moins une fente, et au moins une telle agrafe de fixation insérée dans la fente de sorte que le corps de liaison traverse l'épaisseur de la paroi de support à travers la fente pour positionner la tête d'appui et le pied de contre-appui respectivement de part et d'autre de la paroi de support, et coulissée le long de la fente par un mouvement de coulissement d'ensemble de l'agrafe de fixation suivant la direction transversale de l'agrafe de fixation pour conjointement engager transversalement un segment de la paroi de support et un segment de châssis photovoltaïque dans l'intervalle déterminé entre la tête d'appui et le pied de contre-appui.

### BREVE DESCRIPTION DES DESSINS

D'autres aspects, buts, avantages et caractéristiques de l'invention apparaîtront mieux à la lecture de la description détaillée suivante de modes de réalisation préférés de celle-ci, donnée à titre d'exemple non limitatif, et faite en référence aux dessins annexés sur lesquels :
les figures 1 et 2 illustrent en perspective respectivement avant et arrière un premier exemple d'agrafe de fixation selon l'invention,
les figures 3 et 4 montrent l'agrafe de fixation des figures 1 et 2 à l'état monté sur une paroi de support par insertion à travers une fente,
les figures 5 et 6 montrent l'agrafe de fixation des figures 1 à 4, après coulissement pour venir occuper un état où elle assure un maintien d'un châssis photovoltaïque,
la figure 7 illustre en perspective avant un deuxième exemple d'agrafe de fixation selon l'invention,
les figures 8 et 9 montrent l'agrafe de fixation de la figure 7 à l'état monté sur une paroi de support par insertion à travers une fente,
la figure 10 montre l'agrafe de fixation des figures 7 à 9, après coulissement pour venir occuper un état où elle assure un maintien d'un châssis photovoltaïque,
la figure 11 illustre en perspective arrière un troisième exemple d'agrafe de fixation selon l'invention,
la figure 12 illustre en perspective avant un quatrième exemple d'agrafe de fixation selon l'invention,
la figure 13 illustre en perspective avant un cinquième exemple d'agrafe de fixation selon l'invention,
la figure 14 illustre en perspective avant un sixième exemple d'agrafe de fixation selon l'invention.

### EXPOSE DETAILLE DE MODES DE REALISATION PARTICULIERS

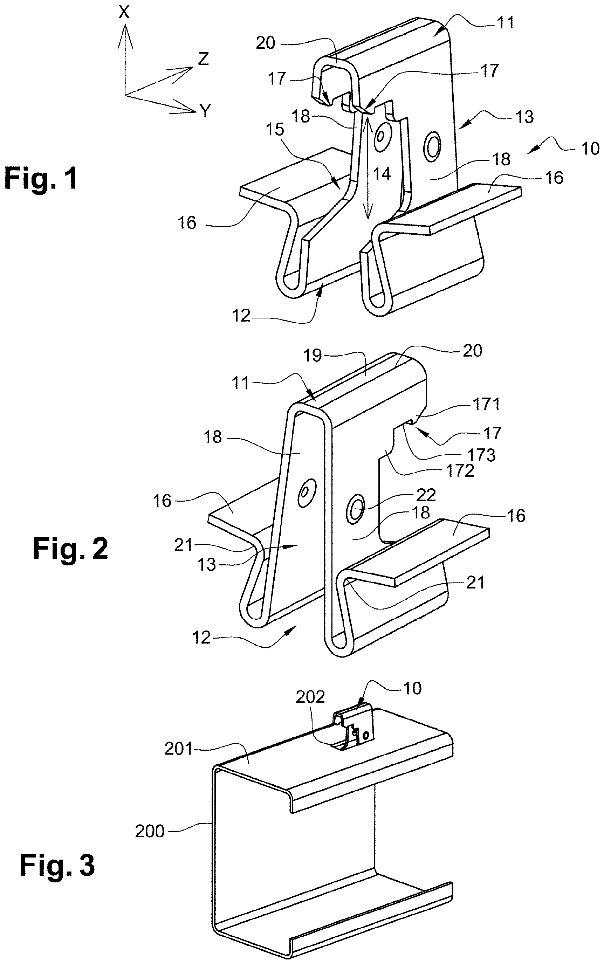

Sur les figures 1 à 14 et dans la suite de la description, les mêmes références représentent les éléments identiques ou similaires. Par ailleurs, les différents modes de réalisation et variantes ne sont pas exclusifs les uns des autres et peuvent être combinés entre eux.

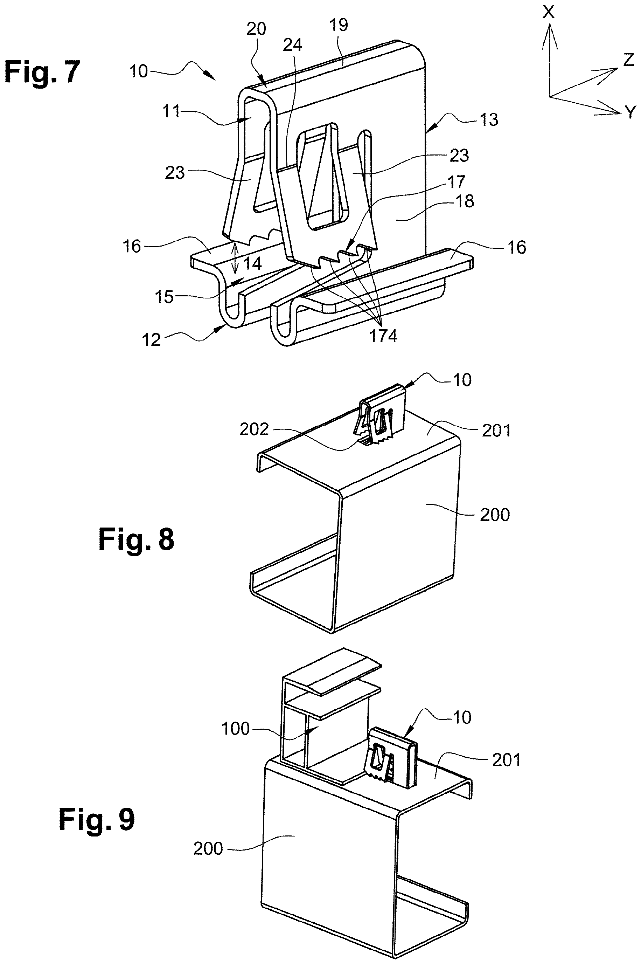

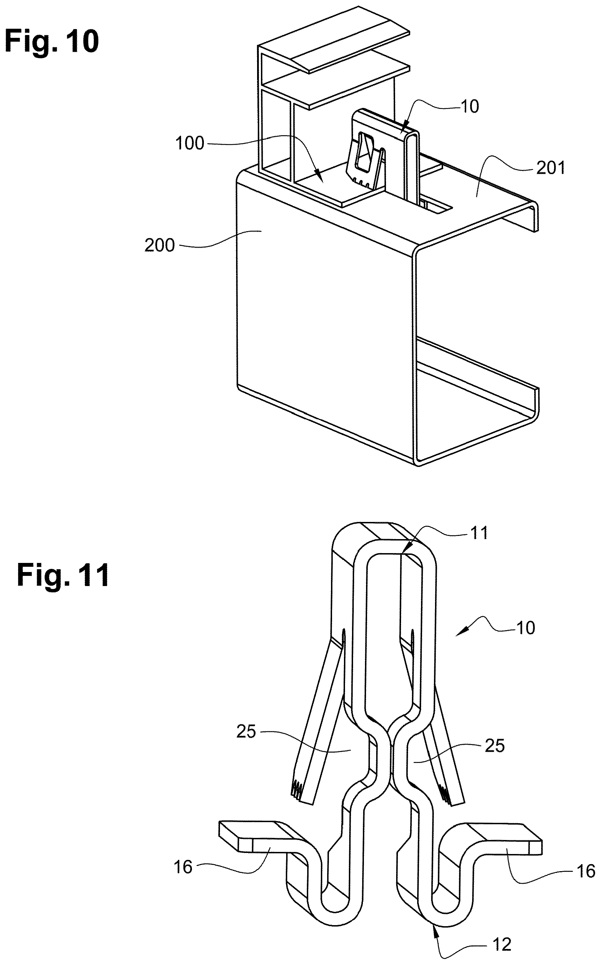

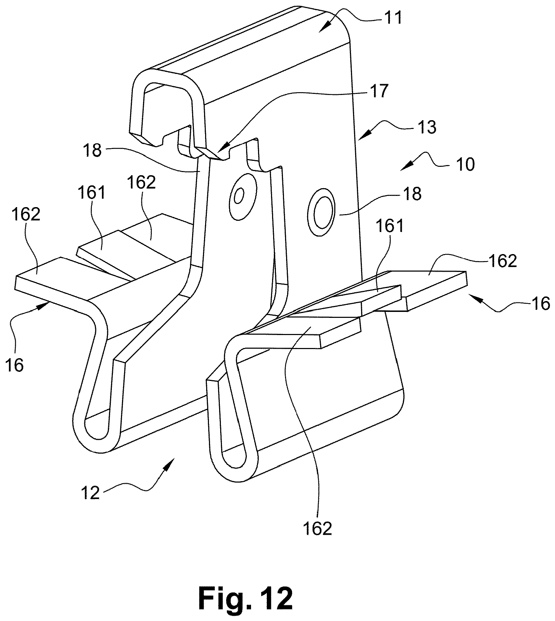

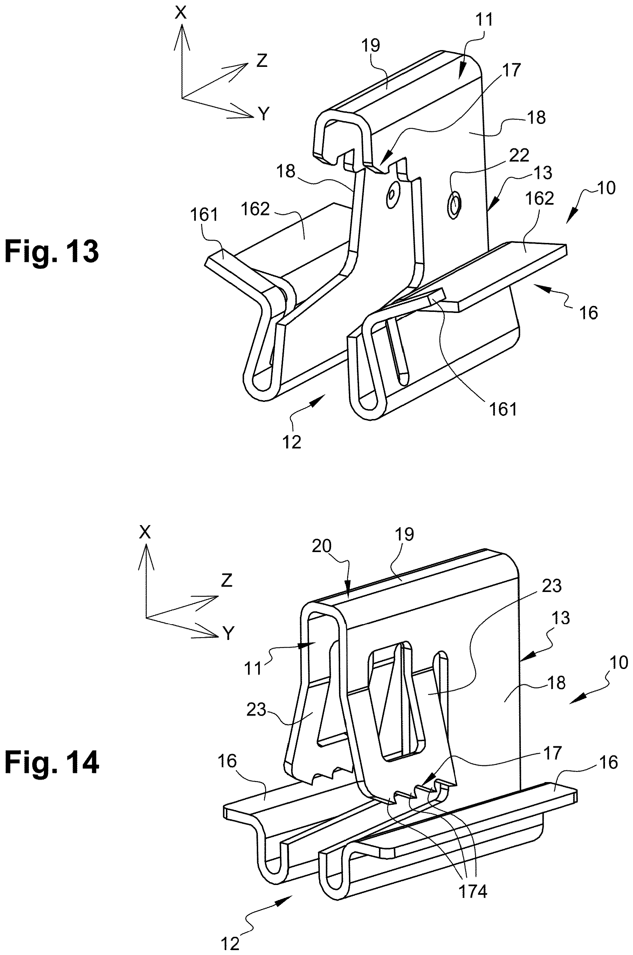

Les figures 1 et 2 représentent un premier exemple d'agrafe de fixation 10 selon l'invention. La figure 7 représente un deuxième exemple d'agrafe de fixation 10 selon l'invention. La figure 11 représente un troisième exemple d'agrafe de fixation 10 selon l'invention. La figure 12 représente un quatrième exemple d'agrafe de fixation. La figure 13 représente un cinquième exemple d'agrafe de fixation 10 selon l'invention, qui est une variante de celle de la figure 12. La figure 14 représente un sixième exemple d'agrafe de fixation 10 selon l'invention, qui est une variante de celle de la figure 7. Les figures restantes montrent la manière dont les agrafes de fixation 10 des deux premiers exemples sont utilisées en fonctionnement.

Chaque agrafe de fixation 10 permet d'une part de maintenir un châssis photovoltaïque 100 avec lequel elle coopère contre une face avant d'une paroi de support 201, d'autre part de mettre au même potentiel électrique le châssis photovoltaïque 100 et la paroi de support 201.

Comme cela peut l'être constaté des figures 3 à 6 et 8 à 10, la paroi de support 201 peut notamment être constituée par l'une des ailes d'une poutre porteuse 200 elle-même destinée à être maintenue à distance du sol au moyen de tout piétement (non représenté) adapté à la poutre porteuse 200 et au terrain. Toutefois, la nature du système dans lequel la paroi de support 201 est agencée n'est pas limitative et ce système peut être quelconque, suivant les applications.

Une installation photovoltaïque est destinée à comprendre une pluralité de châssis photovoltaïque 100. Chaque châssis photovoltaïque 100 est par exemple maintenu en appui contre une première paroi de support 201 solidaire d'une première poutre porteuse 200 au moyen d'au moins deux agrafes de fixation 10 décalées le long de cette première poutre porteuse 200 et contre une seconde paroi de support 201 solidaire d'une seconde poutre porteuse 200 au moyen d'au moins deux agrafes de fixation 10 supplémentaires décalées le long de cette seconde poutre porteuse 200.

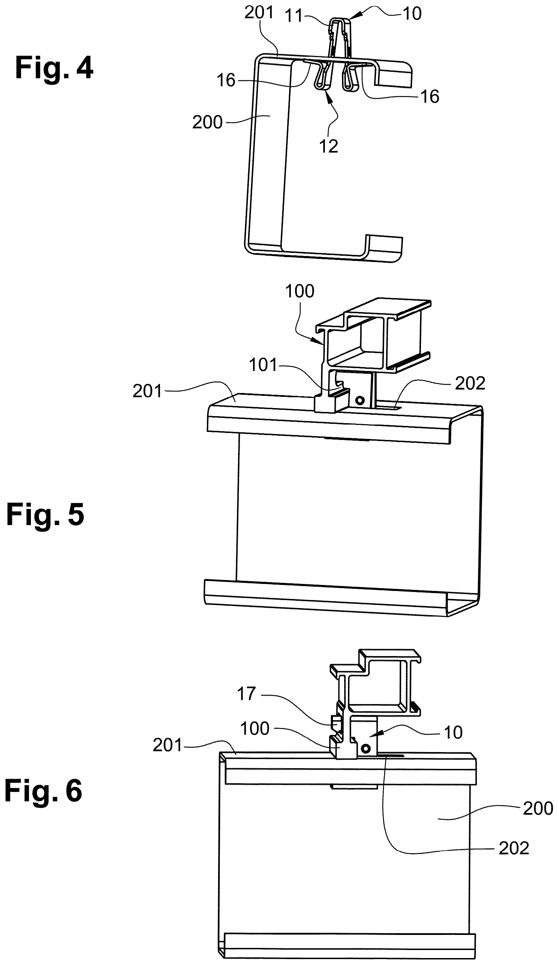

Sur les figures 5, 6, 9 et 10, seule une partie du cadre de structure du châssis photovoltaïque 100 est représentée. Cette partie de cadre de structure peut notamment se présenter sous la forme d'un profilé métallique, dont la section diffère entre le mode de réalisation des figures 5 et 6 et le mode de réalisation des figures 9 et 10. Il est précisé que le châssis photovoltaïque 100 n'est pas véritablement limitatif en soi quant à la diversité des domaines d'application envisageables au sujet de la nature des châssis photovoltaïques 100 qui peuvent être maintenus en place par les agrafes de fixation 10 décrites dans ce document. Par contre, les châssis photovoltaïques 100 fixés grâce à ces agrafes de fixation 10 pourront présenter de grandes dimensions si nécessaire, par exemple une largeur comprise entre 1 m et 1,5 m et une longueur comprise entre 1,5 m et 2,5m, ce qui est un véritable avantage en terme de coût et de facilité de pose.

Chacune des agrafes de fixation 10 des figures 1 à 11 est une pièce formée dans un matériau métallique électriquement conducteur. Cette pièce est d'un seul tenant. Elle peut par exemple résulter d'une opération de découpage d'un patron à partir d'une tôle ou d'un feuillard dudit matériau métallique électriquement conducteur, puis d'opérations successives de pliages de ce patron jusqu'à aboutir à la forme finale de l'agrafe de fixation 10. Chaque agrafe de fixation 10 est ainsi conformée pour délimiter une tête d'appui 11, un pied de contre-appui 12 et un corps de liaison 13 reliant le pied de contre-appui 12 à la tête d'appui 11.

La manière dont est conformée l'agrafe de fixation 10 est telle que la tête d'appui 11 et le pied de contre-appui 12 sont décalés l'un par rapport à l'autre suivant une direction longitudinale X de l'agrafe de fixation 10 par un intervalle déterminé 14.

Pour des raisons de clarté, il est associé un repère orthogonal à chaque agrafe de fixation 10, incluant la direction longitudinale X telle qu'évoquée ci-avant, une direction latérale Y et une direction transversale Z.

Le corps de liaison 13 est adapté à traverser l'épaisseur de la paroi de support 201 à travers l'épaisseur d'une fente 202 ménagée dans la paroi de support 201, par insertion de la tête d'appui 11 à travers la fente 202 suivant la direction longitudinale X pour positionner la tête d'appui 11 et le pied de contre-appui 12 respectivement de part et d'autre de la paroi de support 201.

Par exemple les figures 3 et 4 pour le premier exemple d'agrafe de fixation 10 et la figure 8 pour le deuxième exemple d'agrafe de fixation 10 illustrent la situation obtenue à l'issue de l'insertion longitudinale de la tête d'appui 11 à travers l'épaisseur de la fente 202. La tête d'appui 11 est située en avant de la face avant de la paroi de support 201 tandis que le pied de contre-appui 12 est située en arrière de la face arrière de la paroi de support 201.

Le corps de liaison 13 est également adapté à coulisser, une fois qu'il a préalablement été inséré longitudinalement de la manière décrite au paragraphe précédent, sur tout ou partie de la longueur de la fente 202 par un mouvement de coulissement d'ensemble de l'agrafe de fixation 10 suivant la direction transversale Z de l'agrafe de fixation 10.

Avantageusement, la longueur de la fente 202 est supérieure à la dimension de l'agrafe de fixation 10 suivant la direction transversale, l'écart entre ces deux dimensions étant ajusté et volontairement assez grand afin de permettre une possibilité de réglage de la position occupée par le châssis photovoltaïque 100 par rapport à la paroi de support 201 selon une direction donnée, typiquement orientée selon un axe Est-Ouest. Cela favorise l'implantation de l'installation photovoltaïque sur un terrain non plat.

L'intervalle déterminé 14 entre la tête d'appui 11 et le pied de contre-appui 12 est adapté pour que la tête d'appui 11 et le pied de contre-appui 12 constituent une mâchoire 15 susceptible de conjointement recevoir transversalement un segment de la paroi de support 201 et un segment de châssis photovoltaïque 100 dans une configuration où le châssis photovoltaïque 100 est en appui contre la face avant de la paroi de support 201.

Par exemple les figures 5 et 6 pour le premier exemple d'agrafe de fixation 10 et la figure 10 pour le deuxième exemple d'agrafe de fixation 10 illustrent la situation obtenue à l'issue d'un mouvement de coulissement transversal de l'agrafe de fixation 10 mené jusqu'à placer conjointement un segment de la paroi de support 201 et un segment de châssis photovoltaïque 100 à l'intérieur de la mâchoire 15, c'est-à-dire entre la tête d'appui 11 et le pied de contre-appui 12.

Dans chacun des six exemples d'agrafe de fixation 10, le pied de contre-appui 12 comprend au moins une aile latérale d'appui 16 positionnée longitudinalement pour venir en appui longitudinal contre une face arrière de la paroi de support 201 lorsque le châssis photovoltaïque 100 et la paroi de support 201 sont transversalement engagés dans la mâchoire 15. L'appui de ladite au moins une aile latérale d'appui 16 contre la face arrière de la paroi de support 201 est visible sur la figure 3.

Dans chacun des six exemples d'agrafe de fixation 10, la tête d'appui 11 comprend au moins un élément d'accrochage 17 adapté pour accrocher le châssis photovoltaïque 100 afin d'immobiliser transversalement le châssis photovoltaïque 100 dans la mâchoire 15 une fois que le segment de la paroi de support 201 et le segment de châssis photovoltaïque 100 ont conjointement été placés à l'intérieur de la mâchoire 15 par coulissement transversal de l'agrafe de fixation 10.

Entre autres, les premier et deuxième exemples d'agrafe de fixation 10 diffèrent l'un de l'autre quant à la manière dont est organisé l'élément d'accrochage 17. Ces dispositions seront détaillées plus loin.

Dans chacun des six exemples d'agrafe de fixation 10, celle-ci comprend au moins une aile de mise en tension mécanique dont une déformation élastique et/ou un déplacement, résultant de l'action d'engagement transversal du segment de châssis photovoltaïque 100 et du segment de paroi de support 201 dans l'intervalle déterminé 14 entre la tête d'appui 11 et le pied de contre-appui 12, permet à la tête d'appui 11 et au pied de contre-appui 12 d'exercer un serrage longitudinal du châssis photovoltaïque 100 et de la paroi de support 201 dans la mâchoire 15.

Les premier et deuxième exemples d'agrafe de fixation 10 diffèrent l'un de l'autre également quant à la manière dont est organisée ladite au moins une aile de mise en tension mécanique. Ces dispositions seront détaillées plus loin.

Selon un mode de réalisation particulier non limitatif, auquel répond chacun des six exemples d'agrafe de fixation 10 représentés aux figures 1 à 14, le corps de liaison 13 est constitué par deux parois latérales 18 délimitées par l'agrafe de fixation 10, décalées entre elles suivant la direction latérale Y de l'agrafe de fixation 10 et connectées entre elles à l'une de leurs extrémités longitudinales au niveau de la tête d'appui 11 par une zone de pliage 19. Les extrémités longitudinales opposées des deux parois latérales 18 sont par contre indépendantes l'une de l'autre au niveau du pied de contre-appui 12. Ladite au moins une aile latérale d'appui 16 est solidaire de l'une des parois latérales 18 de sorte à s'étendre latéralement en saillie par rapport à celle-ci.

Ces dispositions techniques garantissent que l'agrafe de fixation 10 présente l'avantage d'être simple à fabriquer et donc d'être économique, de permettre un bon appui latéral des ailes 16, 23 et d'offrir une très grande résistante à la fois l'arrachement en traction selon la direction longitudinale X et au cisaillement selon la direction latérale Y.

Notamment, chaque agrafe de fixation 10 peut comprendre deux ailes latérales d'appui 16 respectivement solidaires des deux parois latérales 18 au niveau du pied de contre-appui 12. Chaque aile latérale d'appui 16 est par exemple agencée dans le prolongement de l'extrémité de la paroi latérale 18 dont elle est solidaire en y étant raccordée par une zone de pliage.

Dans chacun des six exemples d'agrafe de fixation 10, la tête d'appui 11 comprend un bras supérieur 20 s'étendant transversalement en porte-à-faux depuis la zone de pliage 19 et à l'aplomb du pied de contre-appui 12 suivant la direction longitudinale X. Ainsi, la mâchoire 15 adopte une forme générale de U dans le plan (X, Z), dont le fond est matérialisé par le corps de liaison 13 qui relie la tête d'appui 11 et le pied de contre-appui 12.

Dans le premier exemple d'agrafe de fixation 10, l'élément d'accrochage 17 comprend un ergot de retenue 171 et un épaulement 172 solidaires du bras supérieur 20 en étant décalés l'un par rapport à l'autre suivant la direction transversale Z le long du bras supérieur 20, et délimitant entre eux une encoche 173 qui débouche du côté de l'intérieur de la mâchoire 15 et adaptée pour recevoir une nervure 101 du châssis photovoltaïque 100, typiquement solidaire du cadre de structure.

Toujours dans le premier exemple d'agrafe de fixation 10, ladite au moins une aile de mise en tension mécanique est constituée par ladite au moins une aile latérale d'appui 16. Chaque aile latérale d'appui 16 est inclinée de sorte à former un angle par rapport à la direction latérale Y et est raccordée à la paroi latérale 18 dont elle est solidaire par une zone recourbée élastiquement déformable 21 telle que l'aile latérale d'appui 16 est susceptible de s'abaisser longitudinalement, au moins par déformation élastique de cette zone recourbée élastiquement déformable 21 voire par déformation élastique intrinsèque de l'aile latérale d'appui 16, sous l'action de l'engagement transversal du segment de châssis photovoltaïque 100 et du segment de paroi de support 201 dans l'intervalle déterminé 14 entre la tête d'appui 11 et le pied de contre-appui 12.

Dans le premier exemple d'agrafe de fixation 10, les parois latérales 18 sont inclinées de sorte à former un angle avec la direction longitudinale X pour s'approcher l'une de l'autre en s'approchant de la zone de pliage 19. La zone de pliage 19 présente une certaine élasticité telle que les parois latérales 18 sont susceptibles de se rapprocher latéralement l'une de l'autre, par déformation élastique de la zone de pliage 19, le rappel élastique de la matière de la zone de pliage 19 assurant un rappel latéral des parois latérales 18 vers l'extérieur suivant la direction latérale Y.

Une première fonction de ce battement latéral des parois latérales 18 moyennant un rappel élastique vers l'extérieur est de leur permettre de se rapprocher l'une de l'autre durant l'insertion de l'agrafe de fixation 10 à travers la fente 202, la zone de pliage 19 jouant un rôle de rappel latéral externe des parois latérales 18 vers les bords de la fente 202. De manière plus générale, la possibilité de déplacement élastique des parois latérales 18 accompagnée éventuellement, lorsque cela est possible comme c'est le cas dans l'exemple de la figure 1, 12 ou 13, d'une possibilité de déplacement élastique des ailes latérales d'appui 16, crée une élasticité globale et un rôle de rappel dans la direction longitudinale X qui est très utile : non seulement ces possibilités de déplacement facilitent au montage la mise en place d'un segment de la paroi de support 201 et d'un segment de châssis photovoltaïque 100 dans la mâchoire délimitée entre la tête d'appui 11 et le pied de contre-appui 12 par un coulissement de l'agrafe de fixation 10 suivant la direction transversale Z en modifiant l'intervalle déterminé 14, mais cela permet également d'augmenter l'élasticité de l'agrafe de fixation 10 (raideur plus faible, déformation élastique plus grande) dans la direction longitudinale X ainsi que la gamme d'épaisseur de la paroi de support 201 et du châssis 100 tolérée par une agrafe de fixation 10. Cela permet au final d'augmenter l'universalité de l'agrafe de fixation 10 et d'amortir les vibrations à résonance du panneau photovoltaïque 100.

Dans chacun des six exemples d'agrafe de fixation 10 illustrés sur les figures 1 à 12, l'agrafe de fixation 10 comprend des éléments de retenue configurés de sorte à éviter à l'agrafe de fixation 10 d'être retirée longitudinalement hors de la fente 202, par exemple sous le simple effet de la gravité, après son insertion longitudinale, afin d'assurer un blocage positif de l'agrafe de fixation 10 dans la configuration dans laquelle la tête d'appui 11 et le pied de contre-appui 12 sont respectivement de part et d'autre de la paroi de support 201. Par blocage positif, on entend ici que l'agrafe de fixation 10 reste longitudinalement bloqué dans la fente 202, après insertion, tant qu'aucune action humaine tendant à libérer l'agrafe de fixation 10 n'est appliquée.

Dans le premier exemple d'agrafe de fixation 10, les éléments de retenue se présentent sous la forme d'une saillie latérale de maintien 22 formée, par exemple par emboutissage, dans chacune des parois latérales 18 pour être susceptible de venir buter contre la face avant de la paroi de support 201, au niveau des bords de la fente 212, après l'insertion longitudinale de la tête d'appui 11 à travers l'épaisseur de la fente 202. Il en est de même pour les exemples des figures 12 et 13.

Dans le deuxième exemple d'agrafe de fixation 10 maintenant, la tête d'appui 11 comprend deux ailes flexibles 23 indépendantes l'une de l'autre où chaque aile flexible 23 est raccordée au bras supérieur 20 par une zone pliée 24 de sorte à s'étendre chacune en direction du pied de contre-appui 12 de manière inclinée en formant un angle avec la direction longitudinale X. Les deux ailes flexibles 23 convergent l'une vers l'autre en s'approchant du bras supérieur 20. Chaque aile flexible 23 est susceptible de s'écarter latéralement, par déformation élastique de la zone pliée 24 et/ou par déformation élastique intrinsèque de l'aile flexible 23, sous l'action de l'engagement transversal du segment de châssis photovoltaïque 100 et du segment de paroi de support 201 dans l'intervalle déterminé 14 entre la tête d'appui 11 et le pied de contre-appui 12. Il en est de même pour l'exemple de la figure 14.

Dans le deuxième et le sixième exemples d'agrafe de fixation 10 des figures 7 et 14, ladite au moins une aile de mise en tension mécanique est constituée par les deux ailes flexibles 23. Les ailes flexibles 23 constituent également les éléments de retenue précédemment définis, s'affranchissant avantageusement de l'obligation de la présence des saillies latérales de maintien 22 contrairement aux exemples d'agrafe de fixation 10 des figures 1, 12 et 13 pour des raisons de simplicité de fabrication et de coût.

Chaque aile flexible 23 peut être ajourée, comme cela est illustré, afin d'améliorer ses aptitudes de déformation élastique.

Quelle que soit la manière dont est constituée ladite au moins une aile de mise en tension mécanique, sa présence permet d'assurer un maintien sous contrainte du châssis photovoltaïque 100 contre la face avant de la paroi de support 201. Outre les avantages liés à la résistance mécanique de la fixation obtenue, cela fiabilise la mise au même potentiel électrique du châssis photovoltaïque 100 et de la paroi de support 201 conférée par les caractéristiques de conduction électrique intrinsèque de l'agrafe de fixation 10.

Toujours dans les deuxième et sixième exemples d'agrafe de fixation 10 des figures 7 et 14, l'élément d'accrochage 17 comprend une série de dents d'accrochage 174 échelonnées transversalement le long d'un bord distal de l'aile flexible 23 opposé à son bord proximal lié à la zone pliée 24. Les dents d'accrochage 174 sont adaptées pour entailler le segment de châssis photovoltaïque 100 sous l'action de l'engagement transversal du segment de châssis photovoltaïque 100 dans l'intervalle déterminé 14 entre la tête d'appui 11 et le pied de contre-appui 12.

Ainsi, l'intervalle déterminé 14 correspond alors à l'espace entre les dents d'accrochage 174 et les ailes latérales d'appui 16. Cet intervalle déterminé 14 est nettement plus petit que dans le cas du premier exemple d'agrafe de fixation 10, le rendant par exemple adapté à l'engagement d'un segment de châssis photovoltaïque 100 sous la forme d'une base plane, au contraire du cas du premier exemple où le segment de châssis photovoltaïque 100 présente la nervure 101 déjà mentionnée.

Dans chacun du premier exemple et du deuxième exemple d'agrafe de fixation 10, chaque paroi latérale 18 présente, au niveau de la liaison entre le corps de liaison 13 et le pied de contre-appui 12 qui est lui-même en porte-à-faux transversalement par rapport au pied de contre-appui 12, un bord incliné formant un angle par rapport à la direction transversale Z afin de limiter les contraintes internes subies par l'agrafe de liaison 10 dans cette zone, afin d'éviter autant que possible les risques de rupture dans cette zone.

Le troisième exemple d'agrafe de fixation 10, en référence à la figure 11, diffère du deuxième exemple en ce que le corps de liaison 13 délimite au moins une empreinte 25 adaptée pour recevoir et maintenir une partie complémentaire d'un applicateur (non représenté) indépendant de l'agrafe de fixation 10 où ledit applicateur a une aptitude à assurer une fonction de cale martyre pour la mise en œuvre du mouvement de coulissement d'ensemble de l'agrafe de fixation 10 suivant la direction transversale Z par frappe sur l'applicateur, typiquement grâce à un marteau. Une telle empreinte 25 peut par exemple être obtenue par une inflexion latérale sous la forme d'un creux ménagé dans chaque paroi latérale 18 dans une zone donnée de sa hauteur.

Alternativement, il est possible de prévoir un montage au moyen d'un outil adapté inséré non par au-dessus du plan de la paroi de support 201 suivant la direction X mais en dessous de celui-ci. L'outil peut être assez simple, par exemple sous la forme d'une plaque pliée à angle droit dont l'une des extrémités dispose d'une fente présentant une largeur sensiblement égale à la largeur de la fente 202. L'insertion suivant la direction transversale Z de l'agrafe de fixation 10 dans cet outil contribue à comprimer les parois latérales 18 jusqu'à ce qu'elles se touchent et facilite ensuite non seulement l'insertion de l'agrafe de fixation 10 dans la paroi de support 201 suivant la direction longitudinale X mais aussi l'insertion de l'agrafe de fixation 10 suivant la direction transversale Z sur le segment de paroi de support 201 et le segment de châssis photovoltaïque 100 tous deux superposés. En retirant l'outil suivant la direction Z en sens inverse du montage, ce qui est rendu possible soit par l'accroche de l'élément d'accrochage 17 qui retient l'agrafe de fixation 10 relativement au châssis photovoltaïque 100, le serrage élastique dans la direction transversale Z de la paroi de support 201 et du châssis photovoltaïque 100 s'établit. L'agrafe de fixation 10 des figures 12 et 13 s'adaptent très bien à cette méthode, car la zone recourbée élastiquement déformable 21 est en retrait suivant la direction Y par rapport au pied de contre-appui 12.

Le quatrième exemple d'agrafe de fixation 10, qui est représenté sur la figure 12, est quant à lui une variante du premier exemple représenté sur les figures 1 à 6. L'agrafe de fixation 10 de la figure 12 diffère de l'agrafe de fixation 10 quant à la manière de former chacune des ailes latérales d'appui 16. En effet, sur la figure 12, il peut être constaté que chacune des ailes latérales d'appui 16 est subdivisée suivant la direction transversale Z en au moins une aile latérale d'appui supérieure 161 et en au moins une aile latérale d'appui inférieure 162. A titre d'exemple, comme cela est représenté sur la figure 12, chaque aile latérale d'appui 16 est transversalement subdivisée en une unique aile latérale d'appui supérieure 161 et en deux ailes latérales d'appui inférieure 162, l'aile latérale d'appui supérieure 161 étant par exemple située entre les deux ailes latérales d'appui inférieures 162 suivant la direction transversale Z. L'angle formé par ladite au moins une aile latérale d'appui supérieure 161 par rapport à la direction latérale Y est supérieur à l'angle formé par ladite au moins une aile latérale d'appui inférieure 162 par rapport à la direction latérale Y. La différence entre ces angles est typiquement ajustée par un contrôle de la zone recourbée élastiquement déformable 21 qui relie chacune des ailes latérales d'appui supérieure et inférieure 161, 162 à la paroi latérale 18. Ainsi, ladite au moins une aile latérale d'appui supérieure 161 est en saillie vers le haut (c'est-à-dire du côté de la tête d'appui 11), suivant la direction longitudinale X, par rapport à ladite au moins une aile latérale d'appui inférieure 162. Par conséquent, au moment de l'engagement transversal du segment de châssis photovoltaïque 100 et du segment de paroi de support 201 dans l'intervalle déterminé 14 entre la tête d'appui 11 et le pied de contre-appui 12, ladite au moins une aile latérale d'appui supérieure 161 viendra en appui contre la face inférieure de la paroi de support 201, engendrant un abaissement longitudinal de ladite au moins une aile latérale d'appui supérieure 161 au moins par déformation élastique de la zone recourbée élastiquement déformable 21 voire par déformation élastique intrinsèque de l'aile latérale d'appui supérieure 161, avant même l'établissement d'un contact entre ladite au moins une aile latérale d'appui inférieure 162 et la face inférieure de la paroi de support 201.

En conditions normales d'utilisation où seul un maintien du châssis photovoltaïque 100 est recherché conjointement à la mise au même potentiel électrique entre le châssis photovoltaïque 100 et la paroi de support 201, seule ladite au moins une aile latérale d'appui supérieure 161 est en contact avec la face arrière de la paroi de support 201 et joue le rôle d'aile de mise en tension mécanique. Par contre, dans des conditions exceptionnelles d'utilisation où le châssis photovoltaïque 100 ainsi maintenu subit de très grands efforts extérieurs, par exemple en situation de grands vents, favorisant un soulèvement du châssis photovoltaïque 100 par rapport à la paroi de support 201, il en résulte l'application d'efforts très élevés (nettement plus élevés que durant la présence des conditions normales d'utilisation précédemment évoquées) du châssis photovoltaïque 100 sur l'agrafe de fixation 10, ces efforts tendant à soulever longitudinalement l'agrafe de fixation 10 par rapport à la paroi de support 201 étant transmis par l'agrafe de fixation 10 à la paroi de support 201 via le pied de contre-appui 12. Durant ces conditions exceptionnelles d'utilisation, ladite au moins une aile latérale d'appui inférieure 162 vient en contact contre la face arrière de la paroi de support 201, en plus de chaque aile latérale d'appui supérieure 161 déjà en contact. Cela conduit à un abaissement longitudinal de chaque aile latérale d'appui inférieure 162 au moins par déformation élastique de la zone recourbée élastiquement déformable 21 voire par déformation élastique intrinsèque de l'aile latérale d'appui inférieure 162.

Ainsi, dans le quatrième exemple de la figure 12, l'agrafe de fixation 10 comprend deux niveaux de raideurs longitudinales applicables par la mâchoire 15. Un premier niveau de raideur longitudinale est exercé par ladite au moins une aile latérale d'appui supérieure 161. Ce premier niveau de raideur est inférieur à la raideur longitudinale exercée par la mâchoire 15 dans le cas du premier exemple, du fait que ladite au moins une aile latérale d'appui supérieure 161 a une aptitude à se plier et/ou se déformer supérieure à celle de chaque aile latérale d'appui 16 monobloc utilisée dans l'agrafe de fixation 10 de la figure 1. Le deuxième niveau de raideur est supérieur au premier niveau et est exercé par la réunion de ladite au moins une aile latérale d'appui supérieure 161 et de ladite au moins une aile latérale inférieure 162. Dans cette organisation avantageuse, ladite au moins une aile latérale d'appui supérieure 161 et ladite au moins une aile latérale d'appui inférieure 162 sont considérées comme entrant dans la constition de ladite au moins une aile de mise en tension mécanique que comprend l'agrafe de fixation 10.

Le cinquième exemple d'agrafe de fixation 10, qui est représenté sur la figure 13, est quant à lui une variante du quatrième exemple représenté sur la figure 12. Il s'en diffère tout d'abord par le fait qu'au contraire des exemples d'agrafe de fixation visibles sur les figures 1 et 12 où la longueur de la tête d'appui 11 et la longueur du pied de contre-appui 12 suivant la direction transversale Z sont sensiblement égales, la longueur du pied de contre-appui 12 comptée suivant la direction transversale Z est ici supérieure, par exemple de 10 à 30%, à la longueur transversale de la tête d'appui 11. Cela permet d'empêcher encore mieux les risques de déboutonnage de l'agrafe de fixation 10 hors de la paroi de support 201 au cas où la paroi de support 201 venait à s'écarter. Une autre différence entre l'exemple de la figure 13 et celui de la figure 12 consiste dans l'aménagement de l'aile latérale d'appui supérieure 161 et de l'aile latérale d'appui inférieure 162. En effet, dans l'exemple de la figure 13, chacune des ailes latérales d'appui 16 est subdivisée suivant la direction transversale Z en une seule aile latérale d'appui supérieure 161 et en une seule aile latérale d'appui inférieure 162, l'aile latérale d'appui supérieure 161 étant aménagée complétement vers l'avant, c'est-à-dire à l'opposé du fond de la mâchoire.

Le sixième exemple d'agrafe de fixation 10, qui est représenté sur la figure 14, est quant à lui une variante du deuxième exemple représenté sur la figure 7. Il s'en diffère par le fait qu'au contraire de l'exemple d'agrafe de fixation 10 visible sur la figure 7 où la longueur de la tête d'appui 11 et la longueur du pied de contre-appui 12 suivant la direction transversale Z sont sensiblement égales, la longueur du pied de contre-appui 12 comptée suivant la direction transversale Z est ici supérieure, par exemple de 10 à 30%, à la longueur transversale de la tête d'appui 11. Cela permet d'empêcher encore mieux les risques de déboutonnage de l'agrafe de fixation 10 hors de la paroi de support 201 au cas où la paroi de support 201 venait à s'écarter.

L'invention porte également sur une installation photovoltaïque comprenant au moins un châssis photovoltaïque 100, au moins une paroi de support 201 délimitant une face avant contre laquelle le châssis photovoltaïque 100 est en appui et dans laquelle est ménagée au moins une fente 202, et au moins une agrafe de fixation 10 telle que décrite précédemment insérée dans la fente 202. Cette insertion de l'agrafe de fixation 10 est telle que le corps de liaison 13 traverse l'épaisseur de la paroi de support 201 à travers la fente 202 pour positionner la tête d'appui 11 et le pied de contre-appui 12 respectivement de part et d'autre de la paroi de support 201. L'agrafe de fixation 10 est ensuite coulissée le long de la fente 202 par un mouvement de coulissement d'ensemble de l'agrafe de fixation 10 suivant la direction transversale Z de l'agrafe de fixation 10 pour conjointement engager transversalement un segment de la paroi de support 201 et un segment de châssis photovoltaïque 100 dans l'intervalle déterminé 14 entre la tête d'appui 11 et le pied de contre-appui 12.

Chaque agrafe de fixation 10 décrite dans ce document est économique, favorise un montage aisé, rend possible des installations sur des terrains non plats, et est très robuste à l'arrachement et au cisaillement.

Les fentes 202, par ajustement de la position occupée par l'agrafe de fixation 10 le long de la fente 202 dans laquelle elle est montée, permettent avantageusement une première possibilité de réglage de la position occupée par le châssis photovoltaïque 100 par rapport à la paroi de support 201 selon une première direction, typiquement orientée selon un axe Est-Ouest. Dans le même temps, chaque agrafe de fixation 10 offre une seconde possibilité de réglage de la position occupée par le châssis photovoltaïque 100 par rapport à la paroi de support 201 selon une seconde direction, typiquement orientée selon un axe Nord-Sud, par ajustement de la position occupée par le châssis photovoltaïque 100 par rapport à la tête d'appui 11 suivant la direction latérale Y de l'agrafe de fixation 10. Ces deux possibilités de réglages indépendantes et combinables facilitent considérablement les opérations de montage de l'installation photovoltaïque et rendent avantageusement possible d'aménager des installations photovoltaïques sur des terrains non plats.

Un avantage supplémentaire est que l'ensemble décrit dans le présent document fonctionne avec une fente 202 ayant une très faible largeur, par exemple comprise entre 5 et 7 mm. En effet, la présence d'une fente 202 de faible largeur permet d'éviter de diminuer de manière trop importante la résistance de la poutre porteuse 200 qui délimite la paroi de support 201, permettant au final de conserver avantageusement des coûts de production compétitifs pour les poutres porteuses 200 de l'installation.

## Revendications

1. Agrafe de fixation (10) adaptée à la fixation d'un châssis photovoltaïque (100) contre une face avant d'une paroi de support (201), l'agrafe de fixation (10) étant une pièce métallique électriquement conductrice d'un seul tenant conformée pour délimiter :
- une tête d'appui (11) ;
- un pied de contre-appui (12) ;
- un corps de liaison (13) reliant le pied de contre-appui (12) à la tête d'appui (11) de sorte que la tête d'appui (11) et le pied de contre-appui (12) sont décalés l'un par rapport à l'autre suivant une direction longitudinale (X) de l'agrafe de fixation (10) par un intervalle déterminé (14), le corps de liaison (13) étant adapté à traverser l'épaisseur de la paroi de support (201) à travers une fente (202) ménagée dans la paroi de support (201), par insertion longitudinale de la tête d'appui (11) à travers la fente (202) pour positionner la tête d'appui (11) et le pied de contre-appui (12) respectivement de part et d'autre de la paroi de support (201), et à coulisser le long de la fente (202) par un mouvement de coulissement d'ensemble de l'agrafe de fixation (10) suivant une direction transversale (Z) de l'agrafe de fixation (10) ;
agrafe de fixation (10) dans laquelle l'intervalle déterminé (14) entre la tête d'appui (11) et le pied de contre-appui (12) est adapté pour que la tête d'appui (11) et le pied de contre-appui (12) constituent une mâchoire (15) susceptible de conjointement recevoir transversalement un segment de la paroi de support (201) et un segment de châssis photovoltaïque (100) dans une configuration où le châssis photovoltaïque (100) est en appui contre la face avant de la paroi de support (201),
dans laquelle le pied de contre-appui (12) comprend au moins une aile latérale d'appui (16) positionnée longitudinalement pour venir en appui longitudinal contre une face arrière de la paroi de support (201) lorsque le châssis photovoltaïque (100) et la paroi de support (201) sont transversalement engagés dans la mâchoire (15),
dans laquelle la tête d'appui (11) comprend au moins un élément d'accrochage (17) adapté pour accrocher le châssis photovoltaïque (100) afin d'immobiliser transversalement le châssis photovoltaïque (100) dans la mâchoire (15),
dans laquelle la tête d'appui (11) et/ou le pied de contre-appui (12) comprend au moins une aile de mise en tension mécanique dont une déformation élastique et/ou un déplacement, résultant de l'action d'engagement transversal du segment de châssis photovoltaïque (100) et du segment de paroi de support (201) dans l'intervalle déterminé (14) entre la tête d'appui (11) et le pied de contre-appui (12), permet à la tête d'appui (11) et au pied de contre-appui (12) d'exercer un serrage longitudinal du châssis photovoltaïque (100) et de la paroi de support (201) dans la mâchoire (15),
l'agrafe de fixation étant **caractérisée en ce que** le corps de liaison (13) est constitué par deux parois latérales (18) délimitées par l'agrafe de fixation (10), décalées entre elles suivant une direction latérale (Y) de l'agrafe de fixation (10) et connectées entre elles à l'une de leurs extrémités longitudinales au niveau de la tête d'appui (11) par une zone de pliage (19), leurs extrémités longitudinales opposées étant indépendantes l'une de l'autre au niveau du pied de contre-appui (12), ladite au moins une aile latérale d'appui (16) étant solidaire de l'une des parois latérales (18) de sorte à s'étendre latéralement en saillie par rapport à la paroi latérale (18) dont elle est solidaire.

2. Agrafe de fixation (10) selon la revendication 1, **caractérisée en ce que** la tête d'appui (11) comprend un bras supérieur (20) s'étendant transversalement en porte-à-faux depuis la zone de pliage (19) et à l'aplomb du pied de contre-appui (12) suivant la direction longitudinale (X).

3. Agrafe de fixation (10) selon l'une quelconque des revendications 1 ou 2, **caractérisée en ce que** ladite au moins une aile de mise en tension mécanique est constituée par ladite au moins une aile latérale d'appui (16) et **en ce que** ladite au moins une aile latérale d'appui (16) est inclinée de sorte à former un angle par rapport à la direction latérale (Y) et est raccordée à la paroi latérale (18) dont elle est solidaire par une zone recourbée élastiquement déformable (21) telle que l'aile latérale d'appui (16) est susceptible de s'abaisser longitudinalement, au moins par déformation élastique de ladite zone recourbée élastiquement déformable (21), sous l'action de l'engagement transversal du segment de châssis photovoltaïque (100) et du segment de paroi de support (201) dans l'intervalle déterminé (14) entre la tête d'appui (11) et le pied de contre-appui (12).

4. Agrafe de fixation (10) selon la revendication 3, **caractérisée en ce que** chacune des ailes latérales d'appui (16) est subdivisée suivant la direction transversale (Z) en au moins une aile latérale d'appui supérieure (161) et en au moins une aile latérale d'appui inférieure (162), ladite au moins une aile latérale d'appui supérieure (161) étant en saillie du côté de la tête d'appui (11), suivant la direction longitudinale (X), par rapport à ladite au moins une aile latérale d'appui inférieure (162).

5. Agrafe de fixation (10) selon l'une quelconque des revendications 3 ou 4, **caractérisée en ce que** l'élément d'accrochage (17) comprend un ergot de retenue (17) et un épaulement (172) solidaires du bras supérieur (20) en étant décalés l'un par rapport à l'autre suivant la direction transversale (Z) le long du bras supérieur (20), et délimitant entre eux une encoche (173) qui débouche du côté de l'intérieur de la mâchoire (15) et adaptée pour recevoir une nervure (101) du châssis photovoltaïque (100).

6. Agrafe de fixation (10) selon l'une quelconque des revendications 3 à 5, **caractérisée en ce que** les parois latérales (18) sont inclinées de sorte à former un angle avec la direction longitudinale (X) pour s'approcher l'une de l'autre en s'approchant de la zone de pliage (19), les parois latérales (18) étant susceptibles de se rapprocher latéralement l'une de l'autre par déformation élastique de la zone de pliage (19), le rappel élastique de la matière de la zone de pliage (19) assurant un rappel latéral des parois latérales (18) vers l'extérieur suivant la direction latérale (Y).

7. Agrafe de fixation (10) selon la revendication 6, **caractérisée en ce que** chaque paroi latérale (18) comprend une saillie latérale de maintien (22) susceptible de venir buter contre la face avant de la paroi de support (201), au niveau des bords de la fente (202), après l'insertion longitudinale la tête d'appui (11) à travers la fente (202).

8. Agrafe de fixation (10) selon la revendication 2, **caractérisée en ce que** la tête d'appui (11) comprend deux ailes flexibles (23) indépendantes l'une de l'autre où chaque aile flexible (23) est raccordée au bras supérieur (20) par une zone pliée (24) de sorte à s'étendre chacune en direction du pied de contre-appui (12) de manière inclinée en formant un angle avec la direction longitudinale (X), les deux ailes flexibles (23) convergeant l'une vers l'autre en s'approchant du bras supérieur (20), chaque aile flexible (23) étant susceptible de s'écarter latéralement, par déformation élastique de ladite zone pliée (24) et/ou par déformation élastique intrinsèque de l'aile flexible (23), sous l'action de l'engagement transversal du segment de châssis photovoltaïque (100) et du segment de paroi de support (201) dans l'intervalle déterminé (14) entre la tête d'appui (11) et le pied de contre-appui (12) et **en ce que** ladite au moins une aile de mise en tension mécanique est constituée par les deux ailes flexibles (23).

9. Agrafe de fixation (10) selon la revendication 8, **caractérisée en ce que** l'élément d'accrochage (17) comprend une série de dents d'accrochage (174) échelonnées transversalement le long d'un bord distal de l'aile flexible (23) opposé à son bord proximal lié à la zone pliée (24), les dents d'accrochage (174) étant adaptées pour entailler le segment de châssis photovoltaïque (100) sous l'action de l'engagement transversal du segment de châssis photovoltaïque (100) dans l'intervalle déterminé (14) entre la tête d'appui (11) et le pied de contre-appui (12).

## Patentansprüche

1. Befestigungsklammer (10), die zur Befestigung eines Photovoltaik-Rahmens (100) an einer Vorderseite einer Stützwand (201) angepasst ist, wobei die Befestigungsklammer (10) ein elektrisch leitendes Metallteil aus einem Stück ist, ausgeformt, um Folgendes zu begrenzen:
- einen Auflagekopf (11);
- einen Gegenauflagefuß (12);
- einen Verbindungskörper (13), der den Gegenauflagefuß (12) mit dem Auflagekopf (11) verbindet, sodass der Auflagekopf (11) und der Gegenauflagefuß (12) entlang einer Längsrichtung (X) der Befestigungsklammer (10) um ein bestimmtes Intervall (14) in Bezug zueinander versetzt sind, wobei der Verbindungskörper (13) angepasst ist, um die Dicke der Stützwand (201) durch einen Schlitz (202), der in der Stützwand (201) vorgesehen ist, hindurch zu durchqueren, durch Einführen des Auflagekopfes (11) in Längsrichtung durch den Schlitz (202), um den Auflagekopf (11) und den Gegenauflagefuß (12) jeweils beiderseits der Stützwand (201) zu positionieren, und durch eine Gleitbewegung einer gesamten Befestigungsklammer (10) entlang einer Querrichtung (Z) der Befestigungsklammer (10) entlang des Schlitzes (202) zu gleiten;
Befestigungsklammer (10), bei der das bestimmte Intervall (14) zwischen dem Auflagekopf (11) und dem Gegenauflagefuß (12) angepasst ist, damit der Auflagekopf (11) und der Gegenauflagefuß (12) eine Klemmbacke (15) bilden, die in der Lage ist, gemeinsam quer ein Segment der Stützwand (201) und ein Segment eines Photovoltaik-Rahmens (100) in einer Konfiguration aufzunehmen, bei der der Photovoltaik-Rahmen (100) an der Vorderseite der Stützwand (201) aufliegt,
wobei der Gegenauflagefuß (12) mindestens einen seitlichen Auflageflügel (16) umfasst, der längsgerichtet positioniert ist, um längs an der Rückseite der Stützwand (201) aufzuliegen, wenn der Photovoltaik-Rahmen (100) und die Stützwand (201) quer in die Klemmbacke (15) eingeführt werden,
wobei der Auflagekopf (11) mindestens ein Einhakelement (17) umfasst, das angepasst ist, um den Photovoltaik-Rahmen (100) einzuhaken, um den Photovoltaik-Rahmen (100) quer in der Klemmbacke (15) zu blockieren,
wobei der Auflagekopf (11) und/oder der Gegenauflagefuß (12) mindestens einen Flügel für einen mechanischen Spannvorgang umfasst, dessen elastische Verformung und/oder Verschiebung, die aus dem Vorgang eines Einführens des Photovoltaik-Rahmensegments (100) und des Stützwandsegments (201) in Querrichtung in das bestimmte Intervall (14) zwischen dem Auflagekopf (11) und dem Gegenauflagefuß (12) resultiert, es dem Auflagekopf (11) und dem Gegenauflagefuß (12) erlaubt, eine Verspannung des Photovoltaik-Rahmens (100) und der Stützwand (201) in Längsrichtung in der Klemmbacke (15) auszuüben,
wobei die Befestigungsklammer **dadurch gekennzeichnet ist, dass** der Verbindungskörper (13) aus zwei Seitenwänden (18) gebildet wird, die durch die Befestigungsklammer (10) begrenzt sind, sie entlang einer Seitenrichtung (Y) der Befestigungsklammer (10) zueinander versetzt sind, und an einem ihrer Längsenden im Bereich des Auflagekopfes (11) durch eine Biegezone (19) miteinander verbunden sind, wobei ihre gegenüberliegenden Längsenden im Bereich des Gegenauflagefußes (12) voneinander unabhängig sind, wobei der mindestens eine seitliche Auflageflügel (16) derart fest mit der einen der Seitenwände (18) verbunden ist, um sich in Bezug auf die Seitenwand (18), mit der er fest verbunden ist, seitlich vorstehend zu erstrecken.

2. Befestigungsklammer (10) nach Anspruch 1, **dadurch gekennzeichnet, dass** der Auflagekopf (11) einen oberen Arm (20) umfasst, der sich quer überhängend aus der Biegezone (19) und senkrecht zum Gegenauflagefuß (12) entlang der Längsrichtung (X) erstreckt.

3. Befestigungsklammer (10) nach einem der Ansprüche 1 oder 2, **dadurch gekennzeichnet, dass** der mindestens eine Flügel für einen mechanischen Spannvorgang durch den mindestens einen seitlichen Auflageflügel (16) gebildet wird, und dadurch, dass der mindestens eine seitliche Auflageflügel (16) derart geneigt ist, um in Bezug auf die Seitenrichtung (Y) einen Winkel zu bilden, und an die Seitenwand (18), mit der er durch eine elastisch verformbare gekrümmte Zone (21) fest verbunden ist, angeschlossen ist, sodass der seitliche Auflageflügel (16) in der Lage ist, sich längs, mindestens durch elastische Verformung der elastisch verformbaren gekrümmten Zone (21) durch den Vorgang des Einführens des Photovoltaik-Rahmensegments (100) und des Stützwandsegments (201) in Querrichtung in das bestimmte Intervall (14) zwischen dem Auflagekopf (11) und dem Gegenauflagefuß (12) abzusenken.

4. Befestigungsklammer (10) nach Anspruch 3, **dadurch gekennzeichnet, dass** jeder der seitlichen Auflageflügel (16) entlang der Querrichtung (Z) in mindestens einen oberen seitlichen Auflageflügel (161) und in mindestens einen unteren seitlichen Auflageflügel (162) unterteilt ist, wobei der mindestens eine obere seitliche Auflageflügel (161) aus der Seite des Auflagekopfes (11) entlang der Längsrichtung (X) in Bezug auf den mindestens einen unteren seitlichen Auflageflügel (162) hervorsteht.

5. Befestigungsklammer (10) nach einem der Ansprüche 3 oder 4, **dadurch gekennzeichnet, dass** das Einhakelement (17) eine Rückhaltenase (17) und einen Ansatz (172) umfasst, die fest mit dem oberen Arm (20) verbunden sind, und in Bezug zueinander in der Querrichtung (Z) entlang der oberen Armes (20) versetzt sind, und zwischen sich eine Kerbe (173) begrenzen, die auf Seiten der Innenseite der Klemmbacke (15) einmündet und angepasst ist, um eine Rippe (101) des Photovoltaik-Rahmens (100) aufzunehmen.

6. Befestigungsklammer (10) nach einem der Ansprüche 3 bis 5, **dadurch gekennzeichnet, dass** die Seitenwände (18) derart geneigt sind, um mit der Längsrichtung (X) einen Winkel zu bilden, um sich einander anzunähern, indem sie sich der Biegezone (19) annähern, wobei die Seitenwände (18) in der Lage sind, einander seitlich durch elastische Verformung der Biegezone (19) anzunähern, wobei die elastische Vorspannung des Materials der Biegezone (19) für eine seitliche Vorspannung der Seitenwände (18) nach außen entlang der Seitenrichtung (Y) sorgen.

7. Befestigungsklammer (10) nach Anspruch 6, **dadurch gekennzeichnet, dass** jede Seitenwand (18) einen seitlichen Festhalteüberstand (22) umfasst, der in der Lage ist, sich im Bereich der Ränder des Schlitzes (202), nach dem Einführen des Auflagekopfes (11) in Längsrichtung durch den Schlitz (202) an die Vorderseite der Stützwand (201) anzulegen.

8. Befestigungsklammer (10) nach Anspruch 2, **dadurch gekennzeichnet, dass** der Auflagekopf (11) zwei voneinander unabhängige flexible Flügel (23) umfasst, wobei jeder flexible Flügel (23) am oberen Arm (20) durch eine gebogene Zone (24) derart angeschlossen ist, um sich jeweils in Richtung des Gegenauflagefußes (12) in geneigter Form durch Bilden eines Winkels mit der Längsrichtung (X) zu erstrecken, wobei die beiden flexiblen Flügel (23) zueinander zusammenlaufen, indem sie sich dem oberen Arm (20) annähern, wobei jeder flexible Flügel (23) imstande ist, sich durch elastische Verformung der gebogenen Zone (24) und/oder durch intrinsische elastische Verformung des flexiblen Flügels (23) durch den Vorgang des Einführens des Photovoltaik-Rahmensegments (100) und des Stützwandsegments (201) in Querrichtung in das bestimmte Intervall (14) zwischen dem Auflagekopf (11) und dem Gegenauflagefuß (12) seitlich abzuspreizen, und dadurch, dass der mindestens eine Flügel für einen mechanischen Spannungsvorgang durch die beiden elastischen Flügel (23) gebildet wird.

9. Befestigungsklammer (10) nach Anspruch 8, **dadurch gekennzeichnet, dass** das Einhakelement (17) eine Reihe von Einhakzähnen (174) umfasst, die querlaufend entlang einem distalen Rand des flexiblen Flügels (23) gegenüber seinem proximalen Rand, der mit der gebogenen Zone (24) verbunden ist, gestaffelt sind, wobei die Einhakzähne (174) angepasst sind, um das Photovoltaik-Rahmensegment (100) durch den Vorgang des Einführens des Photovoltaik-Rahmensegments (100) in Querrichtung in das bestimmte Intervall (14) zwischen dem Auflagekopf (11) und dem Gegenauflagefuß (12) einzuschneiden.

## Claims

1. A fastening staple (10) adapted for fastening of a photovoltaic framework (100) against a front face of a support wall (201), the fastening staple (10) consisting of an electrically-conductive metallic part integrally made in one piece shaped so as to delimit:
- a bearing head (11);
- a counter-support foot (12);
- a linking body (13) linking the counter-support foot (12) to the bearing head (11) so that the bearing head (11) and the counter-support foot (12) are shifted from each other along a longitudinal direction (X) of the fastening staple (10) by a determined interval (14), the linking body (13) being adapted to cross the thickness of the support wall (201) through a slot (202) formed in the support wall (201), by longitudinal insertion of the bearing head (11) through the slot (202) so as to position the bearing head (11) and the counter-support foot (12) respectively on either side of the support wall (201), and to slide along the slot (202) by an overall sliding movement of the fastening staple (10) in a transverse direction (Z) of the fastening staple (10);
wherein the determined interval (14) between the bearing head (11) and the counter-support foot (12) is adapted such that the bearing head (11) and the counter-support foot (12) constitute a jaw (15) likely to transversely receive both a segment of the support wall (201) and a segment of the photovoltaic framework (100) in a configuration where the photovoltaic framework (100) bears against the front face of the support wall (201),
wherein the counter-support foot (12) comprises at least one bearing lateral flange (16) positioned longitudinally so as to bear longitudinally against a rear face of the support wall (201) when the photovoltaic framework (100) and the support wall (201) are transversely engaged in the jaw (15),
wherein the bearing head (11) comprises at least one hooking element (17) adapted to hook the photovoltaic framework (100) in order to transversely immobilize the photovoltaic framework (100) in the jaw (15),
wherein the bearing head (11) and/or the counter-support foot (12) comprises at least one mechanical tensioning flange where an elastic deformation and/or a displacement thereof, resulting from the action of transverse engagement of the photovoltaic framework (100) segment and of the support wall (201) segment in the determined interval (14) between the bearing head (11) and the counter-support foot (12), enables the bearing head (11) and the counter-support foot (12) to exert a longitudinal tightening of the photovoltaic framework (100) and of the support wall (201) in the jaw (15),
the fastening staple being **characterized in that** the linking body (13) is constituted by two lateral walls (18) delimited by the fastening staple (10), shifted from each other in a lateral direction (Y) of the fastening staple (10) and connected to each other at one of their longitudinal ends at the bearing head (11) by a folding area (19), their opposite longitudinal ends being independent of each other at the counter-support foot (12), said at least one bearing lateral flange (16) being secured to one of the lateral walls (18) so as to extend laterally in projection with respect to the lateral wall (18) to which it is secured.

2. The fastening staple (10) according to claim 1, **characterized in that** the bearing head (11) comprises an upper arm (20) extending transversely in a cantilevered manner from the folding area (19) and directly below the counter-support foot (12) in the longitudinal direction (X).

3. The fastening staple (10) according to any one of claims 1 or 2, **characterized in that** said at least one mechanical tensioning flange is constituted by said at least one bearing lateral flange (16) and **in that** said at least one bearing lateral flange (16) is inclined so as to form an angle with respect to the lateral direction (Y) and is connected to the lateral wall (18) to which it is secured by an elastically-deformable curved area (21) such that the bearing lateral flange (16) is likely to come down longitudinally, at least by elastic deformation of said elastically-deformable curved area (21), under the action of the transverse engagement of the photovoltaic framework (100) segment and of the support wall (201) segment in the determined interval (14) between the bearing head (11) and the counter-support foot (12).

4. The fastening staple (10) according to claim 3, **characterized in that** each of the bearing lateral flanges (16) is split in the transverse direction (Z) into at least one upper bearing lateral flange (161) and into at least one lower bearing lateral flange (162), said at least one upper bearing lateral flange (161) projecting on the bearing head (11) side, in the longitudinal direction (X), with respect to said at least one lower bearing lateral flange (162).

5. The fastening staple (10) according to any one of claims 3 or 4, **characterized in that** the hooking element (17) comprises a retaining lug (17) and a shoulder (172) secured to the upper arm (20) while being shifted from each other in the transverse direction (Z) along the upper arm (20), and delimiting therebetween a notch (173) which opens onto the inside of the jaw (15) and adapted to receive a rib (101) of the photovoltaic framework (100).

6. The fastening staple (10) according to any one of claims 3 to 5, **characterized in that** the lateral walls (18) are inclined so as to form an angle with the longitudinal direction (X) so as to get close to each other by getting close to the folding area (19), the lateral walls (18) being likely to laterally approach each other by elastic deformation of the folding area (19), the elastic return of the material of the folding area (19) ensuring a lateral return of the lateral walls (18) outwardly in the lateral direction (Y).

7. The fastening staple (10) according to claim 6, **characterized in that** each lateral wall (18) comprises a holding lateral projection (22) likely to abut against the front face of the support wall (201), at the edges of the slot (202), after the longitudinal insertion of the bearing head (11) through the slot (202).

8. The fastening staple (10) according to claim 2, **characterized in that** the bearing head (11) comprises two flexible flanges (23) independent of each other where each flexible flange (23) is connected to the upper arm (20) by a folded area (24) so as to extend each towards the counter-support foot (12) in an inclined manner by forming an angle with the longitudinal direction (X), the two flexible flanges (23) converging towards each other by getting close to the upper arm (20), each flexible flange (23) being likely to be separated laterally, by elastic deformation of said folded area (24) and/or by intrinsic elastic deformation of the flexible flange (23), under the action of the transverse engagement of the photovoltaic framework (100) segment and of the support wall (201) segment in the determined interval (14) between the bearing head (11) and the counter-support foot (12) and **in that** said at least one mechanical tensioning flange is constituted by the two flexible flanges (23).

9. The fastening staple (10) according to claim 8, **characterized in that** the hooking element (17) comprises a series of hooking teeth (174) transversely staggered along a distal edge of the flexible flange (23) opposite to its proximal edge linked to the folded area (24), the hooking teeth (174) being adapted to cut into the photovoltaic framework (100) segment under the action of the transverse engagement of the photovoltaic framework (100) segment in the determined interval (14) between the bearing head (11) and the counter-support foot (12).
